(19) **Europäisches Patentamt**

**European Patent Office**

**Office européen des brevets**

(11) **EP 1 401 105 B1**

(12) **EUROPEAN PATENT SPECIFICATION**

(45) Date of publication and mention
of the grant of the patent:
**14.06.2006 Bulletin 2006/24**

(51) Int Cl.:
**H03M 1/10** $^{(2006.01)}$

(21) Application number: **02425563.0**

(22) Date of filing: **17.09.2002**

(54) **Voltage offset compensation method for time-interleaved multi-path analog-to-digital sigma-delta converters and respective circuit**

Offsetspannungskompensationsverfahren für parallele zeitverschachtelte Analog-Digitalwandler sowie Schaltung dafür

Procédé pour la compensation de tension de décalage pour convertisseurs analogiques-numériques parallèles à entrelacement temporel et circuit pour celui-ci

(84) Designated Contracting States:
**AT BE BG CH CY CZ DE DK EE ES FI FR GB GR IE IT LI LU MC NL PT SE SK TR**

(43) Date of publication of application:
**24.03.2004 Bulletin 2004/13**

(73) Proprietor: **Siemens Mobile Communications S.p.A.**
**20126 Milano (IT)**

(72) Inventors:
- **Gatti, Umberto**
  27100 Pavia (IT)
- **Malcovati, Piero**
  27100 Pavia (IT)
- **Ferragina, Vincenzo**
  27100 Pavia (IT)
- **Fornasari, Andrea**
  29100 Piacanza (IT)

(74) Representative: **Giustini, Delio**
**Siemens Mobile Communications S.p.A,**
**Palazzo Gorky**
**Via Monfalcone, 1**
**20092 Cinisello Balsamo (IT)**

(56) References cited:
**US-A- 5 239 299**        **US-B1- 6 414 612**

- DYER K ET AL: "Analog background calibration of a 10 b 40 Msample/s parallel pipelined ADC" SOLID-STATE CIRCUITS CONFERENCE, 1998. DIGEST OF TECHNICAL PAPERS. 1998 IEEE INTERNATIONAL SAN FRANCISCO, CA, USA 5-7 FEB. 1998, NEW YORK, NY, USA,IEEE, US, 5 February 1998 (1998-02-05), pages 142-143,427, XP010278598 ISBN: 0-7803-4344-1
- SONKUSALE S R ET AL: "Background digital error correction technique for pipelined analog-digital converters" ISCAS 2001. PROCEEDINGS OF THE 2001 IEEE INTERNATIONAL SYMPOSIUM ON CIRCUITS AND SYSTEMS. SYDNEY, AUSTRALIA, MAY 6 - 9, 2001, IEEE INTERNATIONAL SYMPOSIUM ON CIRCUITS AND SYSTEMS, NEW YORK, NY: IEEE, US, vol. 1 OF 5, 6 May 2001 (2001-05-06), pages 408-411, XP010541453 ISBN: 0-7803-6685-9
- FU D ET AL: "DIGITAL BACKGROUND CALIBRATION TECHNIQUE FOR TIME-INTERLEAVED ANALOG-TO-DIGITAL CONVERTERS" IEEE JOURNAL OF SOLID-STATE CIRCUITS, IEEE INC. NEW YORK, US, vol. 33, no. 12, December 1998 (1998-12), pages 1904-1911, XP000880492 ISSN: 0018-9200

**Description**

**FIELD OF THE INVENTION**

The present invention relates to the conversion of electrical signals into the digital form, and more precisely to a voltage offset compensation method for time-interleaved multi-path analog-to-digital sigma-delta converters and a respective circuit.

**BACKGROUND ART**

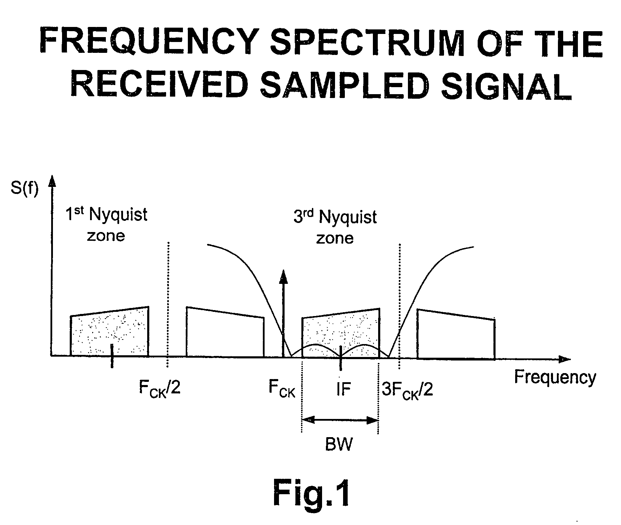

The majority of the nowadays applications in the field of electronic instrumentation and telecommunications require integrated Analog-to-Digital Converters (ADC) having increasingly higher operation speed, and requiring at the same time exceptional performances in terms of linearity and resolution. For instance, the specifications of the ADCs employed in the receiving section of wide-band Base Transceiver Stations (BTSs) based on the GSM 900 MHz, DCS1800 MHz, and UMTS standards, depending on the chosen architecture, require a minimum sampling frequency of 65 MHz, a resolution higher than 12 bits and an SFDR (Spurious Free Dynamic Range) higher than 80 dBFS (dB Full Scale). The latest evolutions in Software Radio (SWR) architectures of the BTSs foresee that the receivers operate over a wide band (at least 5 MHz) at an intermediate frequency (IF) of some tens of Megahertz (typically 70-80 MHz). Indeed, conventional available ADCs when used over such high IF work in their third Nyquist zone, as shown in **fig.1** in which the sampling frequency is $F_{CK}$, where their linearity significantly degrades unless they are forced to operate with exceptionally high sample rates. Moreover, using conventional ADC with a "low-pass" transfer function extended over the third Nyquist zone for handling signal with a bandwidth centred around IF is a waste of resources.

Known sigma-delta converters are able to feature a "band-pass" transfer function, centred at the desired IF. Such a solution allows to digitise the only band around IF, thus reducing the in-band thermal noise requirements and to optimise the quantization noise and the linearity in the only band of interest. In sigma-delta ADCs the sampling frequency is essentially determined by the oversampling ratio OSR = $F_{CK}$/2BW required to obtain the desired Signal-to-Noise Ratio (SNR) with a given signal bandwidth BW, so that the higher is OSR the better is the SNR. A significant work in the field of sigma-delta converters is the following: **[Ref.1]** - S. Norsworthy, R. Schreirer, G. Temes, "Delta-Sigma Data Converters - Theory, Design and Simulation", IEEE Press, NJ, USA,

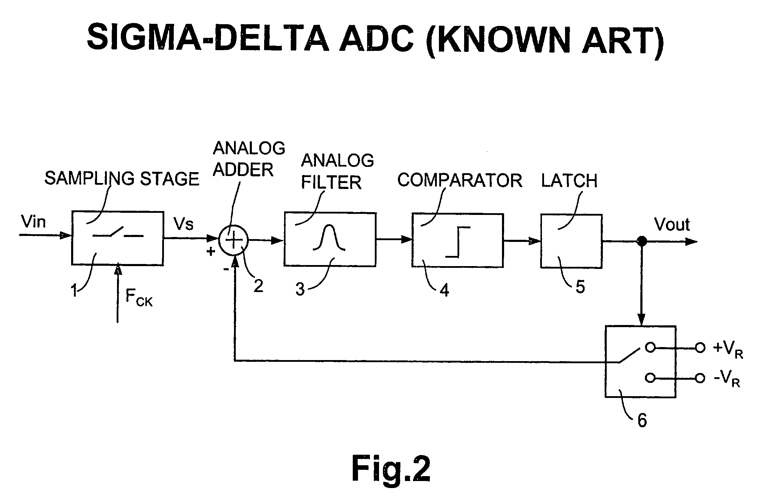

**Fig.2** shows a general block diagram of a band-pass sigma-delta converter (or $\Sigma\Delta$ or delta-sigma). With reference to the Figure the following blocks are cascaded: a sampling stage 1 for sampling the analog input signal Vin at a sampling frequency $F_{CK}$, an analog 2-input adder (subtractor) 2, an analog band-pass filter 3, an analog comparator 4, and a latch 5 for outputting an 1-bit digital signal Vout. An electronic switch 6 controlled by the digital signal Vout selects either a reference voltage $+V_R$ or $-V_R$ to the second input (-) of the analog adder 2.

In operation, the sampling frequency $F_{CK}$ is higher than the Nyquist limit and the sigma-delta is an oversampling converter consequently. The analog filter 3 has a band-pass transfer function of the first order, suitably centred at the desired IF. The comparator 4 together with latch 5 constitutes a quantizer operating as 1-bit ADC. The switch 6 and the two thresholds $+V_R$ and $V_R$ constitute a feedback de-quantizer operating as 1-bit DAC. As it is well known, the same structure can be extended also to multi-bit solutions.

The feedback structure of the sigma-delta converter makes it intrinsically less sensitive to component matching with respect to conventional ADC and allows the quantization noise, introduced by the comparator 4, to be shifted out of the signal band. This last effect, called noise shaping, makes the Signal Transfer Function (STF) different from that of the quantization Noise Transfer Function (NTF); the filter 3 provides the necessary transfer function to obtain the desired STF and NTF functions. The combined effect of over-sampling and noise shaping enables to obtain high resolutions with reasonable clock frequencies. For the first order sigma-delta modulator the two parameters OSR and SNR are linked together by the following equation:

$$SNR_{dB} = -3.41 + 9\,log_2\,OSR \qquad\qquad (E1)$$

Thus, a high oversampling OSR parameter is a key point in sigma-delta ADC to obtain excellent performances. The obvious way is to increase the clock frequency $F_{CK}$ by exploiting the characteristics of state-of-the-art CMOS manufacturing processes with very reduced physical size, or bipolar, or bipolar-CMOS (BiCMOS) integration technologies. However, the use of these technologies implies an increase in manufacturing costs; moreover, a fast clock $F_{CK}$ stresses the operations of the internal blocks 1 to 6 of the ADC converter (fig.2).

An attractive way to increase the conversion rate of ADCs (of any type) without exploiting too fast sampling clocks is to use time-interleaving techniques where several ADCs, using different clock phases, are operated in parallel.

Thus, by using time-interleaved techniques applied to sigma-delta structures very high overall sampling rate can be achieved and consequently high SNR performance. Significant publications in time-interleaved ADCs are the following:

- **[Ref.2]** - W. C. Black, D. A. Hodges, "Time Interleaved Converter Arrays", IEEE J. of Solid-State Circuits, Vol. SC-15, pp. 1022-1029, Dec. 1980.
- **[Ref.3] -** US Patent 4633226 A, W. C. Black, 30 Dec. 1986.
- **[Ref.4] -** US Patent 5585796, C. M. Svensson J. Youan, 17 Dec. 1996.

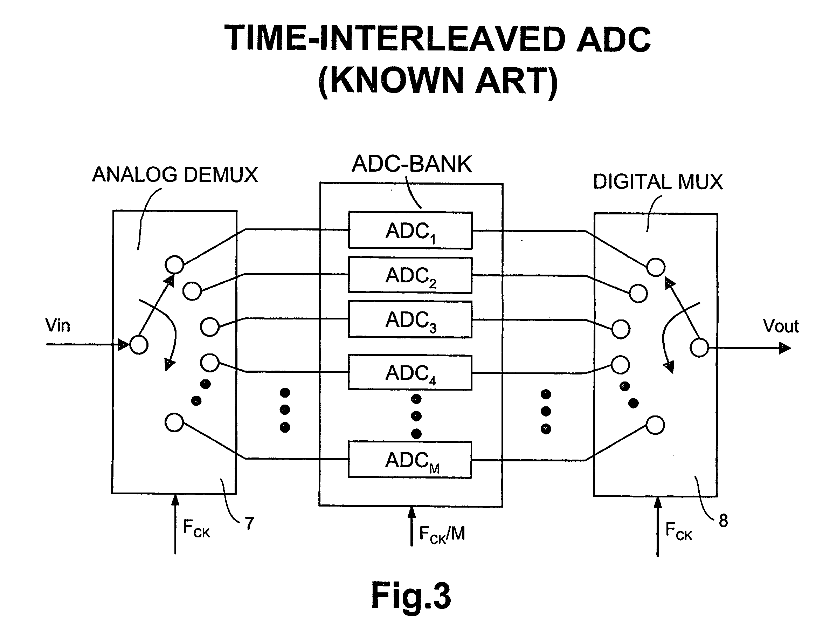

**Fig.3** illustrates in outline a time-interleaved ADC of the known art including an analog demultiplexer 7 operated at $F_{CK}$ clock for distributing the input signal $V_{in}$ in turn to M identical $ADC_1$, $ADC_2$, ...., $ADC_M$ converters. The outputs of $ADC_{1 \text{ to } M}$ converters are connected to respective inputs of a digital demultiplexer 8 operated at $F_{CK}$ clock which in turn forwards the $ADC_{1 \text{ to } M}$ output signals to the unique $V_{out}$ port, thus forming a high-speed digitally converted signal $V_{out}$. The converters $ADC_{1 \text{ to } M}$ can be of any type and are operated at $F_{CK}/M$ where $F_{CK}$ is the total sampling frequency of the time-interleaved ADC and M is the number of channels (or paths). The speed requirements on each converter are relaxed by a factor M. Obviously, the number of converters is at the same time increased by the same factor, resulting in a large chip area and high power consumption.

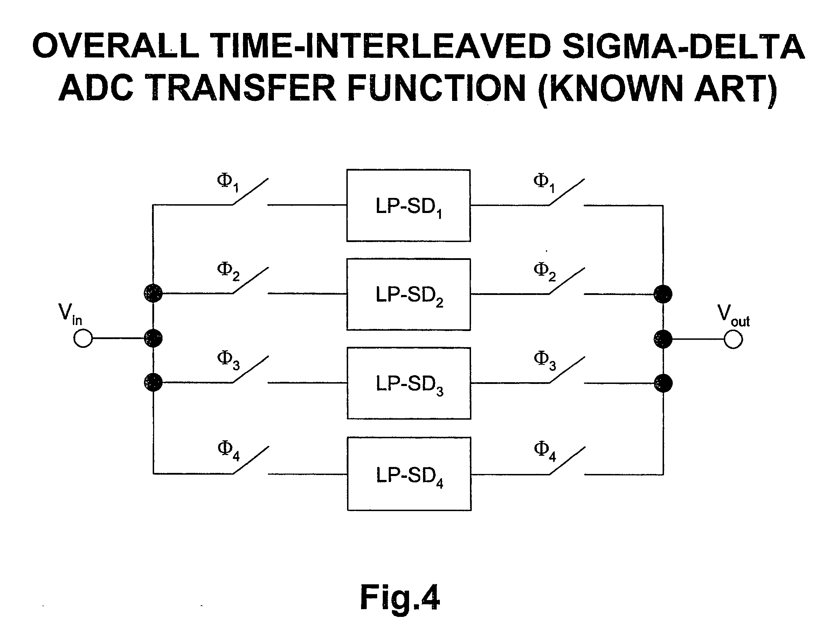

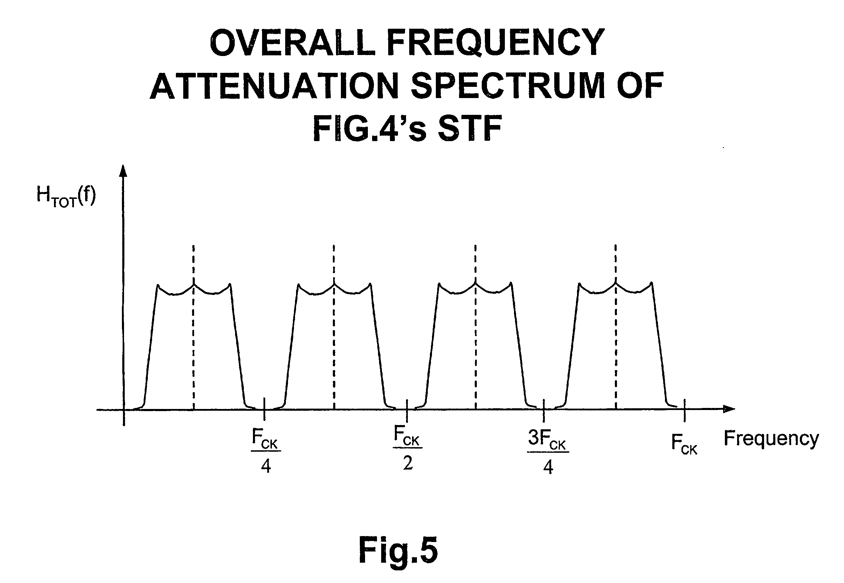

**Fig.4** shows an example of implementation of a time-interleaved ADC like the one of the preceding **Fig.3** based on a 4-path band-pass sigma-delta ADC. The detail of the ADC of fig.4 is disclosed in the following **[Ref.5]:** A. Centuori, U. Gatti, P. Malcovati, F. Maloberti, "A 320-MHz Four-Paths Bandpass Sigma-Delta Modulator", Proc. IEEE Instrum. and Meas. Techn. Conference, Anchorage, AK, USA, pp. 497-500, incorporated by reference. With reference to the **fig. 4** each channel $LP\text{-}SD_{1 \text{ to } 4}$ features a low-pass signal transfer function STF (and high-pass NTF) at a clock frequency $F_{CK}/4$ of a respective timing signal $\Phi_1$ to $\Phi4$. If $T_{ck}$ is the sampling period at the modulator output (not visible in the Figure), $\Phi_1$ to $\Phi_4$ signals have a period equal to $4T_{ck}$ and are phases shifted each other by a quarter of the period; from the theory of multiple path circuits in the z-domain it can be demonstrated that:

$$H_{TOT}(z) = \frac{V_{out}(z)}{V_{in}(z)} = H_P(z^4) \qquad (E2)$$

where $H_P(z)$ is the signal transfer function of the single path $LP\text{-}SD_i$. If $H_P(z)$ has low-pass shape, its attenuation spectrum is replicated every $F_{ck}/4$, as shown in **fig.5** for the $H_{TOT}(f)$ frequency spectrum, thus leading to the desired band-pass signal transfer function around IF (and consequently notch transfer function for the quantization noise). The choice of using 4 ADC channels and an equivalent global sampling frequency equal to 4 times the intermediate frequency (IF = $F_{ck}/4$), where the signal band is located, is profitable since it makes easier the demodulation of input signals, as it results evident to those skilled in the art. The main advantage of this solution is that every channel operates at a frequency that is a quarter of the equivalent converter speed. Moreover, the low-pass transfer function is inherently less sensitive to capacitance mismatches than the band-pass transfer function. Finally, the multi-path topology allows achieving the same SNR performance than single-path topologies with a higher-order filtering, with benefits in the stability and in the complexity design. Unfortunately, any mismatch between the time-interleaved channels gives rise to degradation in the linearity performances. In particular, the mismatch of the voltage offset value in the different paths is the most critical one and is a priori unpredictable. The voltage offset mismatch can generate severe limitation in the maximum Spurious-Free Dynamic Range (SFDR) and SNR performance. For example a mismatch of 10 $mV_{RMS}$ of the offsets introduces a degradation of 60 dB in the converter SNR and SFDR parameters. More in detail, the performance of the time-interleaved converter is of course limited by the accuracy of the ADCs in every path, but there are additional errors caused by mismatches between the channels. There are three main sources of error in the time-interleaved systems, phase skew errors, gain errors and voltage offset. The latter is the most critical one for the receiver application since it causes the raising of signal independent tones located at $(F_{ck}/M) \times N$ (N = 0, 1, ... M-1), exactly where the wanted input signal is present. This drawback is pointed out in the following **[Ref.6]:** M. Gustavsson, J. J. Wikner, N. N. Tan, "CMOS Data Converters for Communications", Kluwer Academic Publishers, Boston, USA, 2000). Indeed, the digital output spectrum of a time-interleaved ADC with offset mismatch is given in **[Ref.7]:** Y. C. Jenq, "Digital Spectra of Nonuniformly Sampled Signals: Fundamentals and High-Speed Waveform Digitizers", IEEE Trans. On Instrum. And Meas., Vol. 37, pp. 245-251, June 1988, by the following expression:

$$G(\omega) = G_s(\omega) + \frac{1}{T_{CK}} \sum_{k=-\infty}^{\infty} A(k) \cdot 2\pi\delta\left(\omega - k\left(\frac{2\pi}{MT_{CK}}\right)\right) \qquad \text{(E3)}$$

where $G_s(\omega)$ is the digital spectrum of an input sine wave sampled at $F_{CK} = 1/T_{CK}$, and:

$$A(k) = \sum_{m=0}^{M-1}\left(\frac{1}{M} \cdot o_m\right) \cdot e^{-j2\pi\frac{km}{M}} \qquad \text{(E4)}$$

where $o_m$ is the offset in the m-th channel. The second term in the expression of $G(\omega)$ represents the tones caused by path offsets which degrade the ADC performance.

Generally speaking, in the past the above-mentioned limitation made difficult the use of interleaved multi-path topologies for high-resolution A/D converters, especially sigma-delta. Spectral analysis shows that the distortion power of offset dispersion is not frequency dependent and thus it can be compensated using appropriate calibration techniques. These last can be divided between off-line and on-line techniques. The former are easier to be implemented since they can be done in factory by trimming voltages/currents as illustrated in **[Ref.8]:** M. Yotsuyanagi, T. Etoh, K. Hirata, "A 10-b 50-MHz Pipelined CMOS A/D Converter with S/H", IEEE J. of Solid-State Circuits, Vol. SC-28, pp. 292-300, March 1993. However, this off-line solution is unable to track offset variations with temperature or ageing over time. Another one is based on calibration procedures applied foreground as illustrated in **[Ref.9]:** C. S. G. Conroy, D. W. Cline, P. R. Gray, "An 8-b 85-MS/s Parallel Pipeline A/D Converter in 1-μm CMOS", IEEE J. of Solid-State Circuits, Vol. SC-28, pp. 447-454, April 1993. However, the calibration interrupts the conversion of the input signal. Finally, a specifically off-line solution is dedicated to sigma-delta ADC in the following **[Ref.10]:** R. Khoini-Poorfard, L. B. Lim, D. A. Johns, "Time-Interleaved Oversampling A/D Converters: Theory and Practice", IEEE Trans. On Circuits and Systems II: Analog and Digital Signal Processing, Vol. 44, pp. 634-645, Aug. 1997. However, this solution is based on finding the optimum value for a cross-coupling coefficient by carrying out extensive simulations during the design step. Again this solution cannot correct variations of the offsets with temperature or ageing.

Indeed, on-line calibration techniques are more difficult to implement, since they operate in background while the ADC is working normally. Several solutions for achieving on-line calibration has been presented before: they can be analog or digital. Usually it is preferred to operate in the digital domain, since the digital world it less prone to inaccuracy and digital data are easier to be processed. Unfortunately most popular on-line calibration techniques are only suitable for deterministic interleaved ADC and cannot be applied to sigma-delta modulators in view of their stochastic behaviour making the output signals obtained with the same input signal at different times each other different depending on the previous history.

An analog on-line calibration method for deterministic interleaved A/D converter exploiting an additional path is disclosed in **[Ref.11]:** K.C. Dyer; D. Fu, S. H. Lewis, P. J. Hurst, "Analog Background Calibration of a 10-b 40 MS/s Parallel Pipelined ADC", Proc. IEEE Int. Solid-State Circuits Conf., pp. 142-143, Feb. 1998. Having M+1 paths available, one of them can always be calibrated while the remaining M operate the conversion. Once a path is calibrated it can replace another path, which is in turn calibrated. Each path is hence calibrated periodically. Apart the difficulty of operating in the analog domain, this technique cannot be applied to sigma-delta ADC because of their stochastic behaviour. In fact, it is not possible to replace a path of the interleaved A/D converter with the calibrated path without introducing a discontinuity in the output, because the history of the two paths is different. This discontinuity produces a strong degradation in the SNR, which makes the calibration ineffective.

A first digital on-line calibration technique has been proposed in **[Ref.12]:** D. Fu, K.C. Dyer; S. H. Lewis, P. J. Hurst, "A Digital Background Calibration Technique for Time-Interleaved Analog-to-Digital Converters", IEEE J. of Solid-State Circuits, Vol. SC-33, pp. 1904 -1911, Dec. 1998. It is based on the addition of a calibration signal, generated by a pseudo-random number generator, to the ADC input and on processing both simultaneously by means of an adaptive algorithm. There is no need for an extra parallel channel. This on-line method can be applied to any type of ADC, however it exhibits some severe limitations pointed out in the following **[Ref.13]:** K.C. Dyer; D. Fu, P. J. Hurst, S. H. Lewis, "A Comparison of Monolithic Background Calibration in Two Time-Interleaved Analog-to-Digital Converters", Proc. of the IEEE Int. Symp. of Circuits and Systems, pp. 13-16, May 1998. Part of the full-scale input range of the ADC is used by the calibration signal. Therefore, the ADC paths require extra resolution to achieve a certain dynamic range. Moreover, the input signal cannot have frequency components at or near $F_{CK}/M$ because signals at this frequency cannot be distinguished from any offset mismatch. The last effect prevents the use of this calibration method in application like those mentioned before where the wanted signal is just located around $F_{CK}/M$. One way to overcome this problem is to stop offset calibration when the input signal is present, unfortunately loosing the advantages of the on-line approach.

Apparently only one other on-line calibration method suitable to be applied to time-interleaved sigma-delta ADC has been presented till now; the following citations are regarding it :

- **[Ref.14] -** J. E. Eklund, F. Gustafsson, "Digital Offset Compensation of Time-Interleaved ADC Using Random Chopper Sampling", Proc. of the IEEE Int. Symp. of Circuits and Systems, pp. 447-450, May 2000;
- **[Ref.15] -** WO Patent application 00/60743, J. E. Eklund, F. Gustafsson, O. G. Svenssons, 7 April 1999,
- **[Ref.16]** - T. Ndjountche, R. Unbehauen, "Design Techniques for High-Speed Sigma-Delta Modulators", Proc. of the 43rd IEEE Midwest Symp. on Circ. And Syst., pp. 916-919, August 2000;
- **[Ref.17]** -T. Ndjountche, R. Unbehauen, "Adaptive calibration techniques for time-interleaved ADCs", Electronics Letters, Vol. 37, Issue 7, pp. 412-414, 29 March 2001).

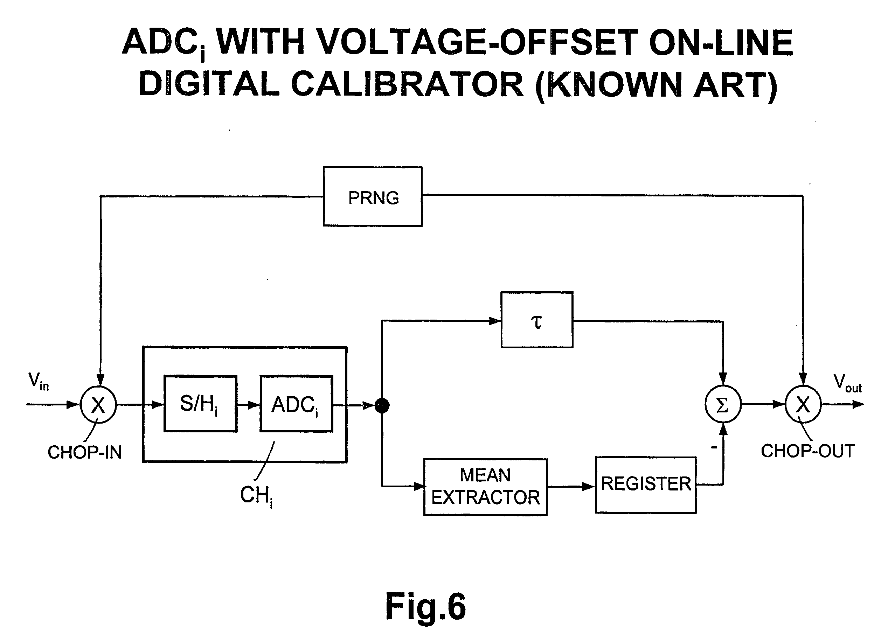

The implementation of the latter method is shown in **fig.6** where, for brevity, one only path is shown. With reference to the **fig.6** the sample-and-hold S/H$_i$ and the ADC$_i$ of the i-th path CH$_i$ are provided with the following calibration blocks: CHOP-IN, PRNG, MEAN EXTRACTOR, REGISTER, $\tau$, $\Sigma$, and CHOP-OUT.
The principle of operation is as follows:

- the input signal $V_{in}$ before the sample-and-hold S/H$_i$ is chopped by block CHOP-IN with a pseudo-random sequence of +1 and -1 coming from block PRNG;
- then the obtained signal (analog) is sampled and digitised by the tandem of blocks S/H$_i$ and ADC$_i$;
- block MEAN EXTRACTOR calculates the mean value of one time slot of digital outputs and stores it in the block REGISTER;
- block $\Sigma$ estimates the offset value by subtracting the mean value stored in the block REGISTER from the input signal digitised by ADC$_i$ and opportunely delayed by block $\tau$;
- the result is chopped by block CHOP-OUT with the same sequence as the input signal, which is thus restored.

The chopping transforms any input signal into noise with mean value equal to 0 before the offset is estimated and removed. In this way the randomisation process allows to overcome the limitation of **[Ref.13]**, which was ineffective for signal located around $F_{CK}/M$. Moreover, the estimation of a new offset value is calculated form each time slot and its value is updated during normal operations. Finally, the method is generic and can be applied to any type of ADC. However, it suffers from two problems: the chopper operates on the analog section of the converter, which is very sensitive to parasitics. Since high linearity and resolution are required the influence of the calibration circuit on the analog first stage of the converter could be critical. Moreover, this method cannot correct any non-ideality of additional front-end located before the chopping.

## OBJECT OF THE INVENTION

The main object of the present invention is that to overcome the above-mentioned limits in time-interleaved multi-path ADCs, in particular by providing an on-line digital calibration technique that allows to reduce the amplitude of the undesired tones caused by mismatches between the offsets of the different paths and that is easy to use in any type of analog-to-digital converters, especially sigma-delta.

## SUMMARY AND ADVANTAGES OF THE INVENTION

To achieve said object the subject of the present invention is a method for compensating the voltage offset of the various paths in a multi-path time-interleaved analog-to-digital converter exploiting an additional reference path cyclically connected in parallel to each of the M paths to be calibrated for calculating the differences between successive digital outputs of the two paths, and accumulating the differences over a given time slot, thus producing a digital word which is added to the output of the path under calibration, preventively multiplied by a scale factor which depends on the length of the given time slot, making the offset of each path depending on the offset of the only reference path, as disclosed in claim 1.

Other object of the method invention is an embodiment in which the accumulation of the differences between successive digital outputs of the reference and the calibrating paths is completed with the average over the number of samples considered in the given time slot, and the multiplication by a scale factor is unnecessary, as disclosed in the independent claim 2. The two embodiments are substantially equivalent as far as concern the offset compensation, but hardware implementation of first embodiment is simpler because in the second as many digital divisions as the M paths are needed.

The method of the invention allows continuously running background calibration since it does not affect the normal operation of the ADC under calibration. Moreover since the M paths are never disconnected from the input signal, no discontinuity is produced and this method can be applied to any kind of analog-to-digital converter, in particular time-interleaved sigma-delta ADC, to whom conventional calibration methods cannot be applied because of their stochastic behaviour.

A preferred embodiment of the invention is a circuit that performs the operations foreseen by the on-line voltage offset compensation method, as disclosed in a relative independent claim. This digital circuit can be implemented with an external FPGA (Field Programmable Gate Arrays) or integrated on the same chip together with the time-interleaved ADC and occupies a moderate silicon area. The last solution constitutes a time-interleaved ADC having high operating frequency together with satisfactory SNR and SFDR, as required by recent BTS standards, without using particular manufacturing technologies.

In consequence of that, further object of the invention is a multi-path analog-to-digital converter including offset-compensating means operating as per the claimed method. Main advantages of the analog-to-digital converter of the invention are:

- the accuracy of the offset equalisation is limited only by the allowed calibration time slot and hardware capability;
- there are no special requirement on the original offset value, thus the interleaved channels can be designed using conventional integration manufacturing technologies without sacrificing the precision of the output signal;
- this solution works with any input signals frequencies, also with signal located around $F_{CK}/M$;
- this solution is independent of the ADC topology because the calibration principle can be applied to any interleaved data converters, such as sigma-delta and pipelined;
- this solution is simple to implement because only one additional path and some digital logic is required and no special calibration input signals is required;
- cyclic repetition of the calibration steps is able to track offset variations with temperature or ageing over time.

## BRIEF DESCRIPTION OF THE DRAWINGS

The features of the present invention which are considered to be novel are set forth with particularity in the appended claims. The invention, together with further objects and advantages thereof, may be understood with reference to the following detailed description of an embodiment thereof taken in conjunction with the accompanying drawings given for purely non-limiting explanatory purposes and wherein:

- **fig.1** (already disclosed) shows the overall spectrum of a sampled signal obtained by sampling the signal received in a wide-band BTS and converted at IF;
- **fig.2** (already disclosed) shows the general diagram of an analog-to-digital sigma-delta converter;
- **fig.3** (already disclosed) shows a simplified block diagram of M time-interleaved ADCs;
- **fig.4** (already disclosed) shows a simplified block diagram of the 4-paths sigma-delta ADC reported in **[Ref.4];**
- **fig.5** (already disclosed) shows the attenuation output spectrum of the 4-paths sigma-delta ADC reported in **[Ref.4];**
- **fig.6** (already disclosed) shows the block diagram of digital offset calibration for interleaved ADC reported in **[Ref. 15]** (one channel only is shown);
- **fig.7** shows a functional block diagram of a 4-path time-interleaved ADC equipped with the on-line offset calibration circuit object of the invention;
- **fig.8** shows a time diagram of the control signals generated by a block SIGNAL-GEN of fig.7;
- **fig.9** shows a simplified block diagram of a preferred embodiment of the on-line offset compensation circuit object of the invention applied to a 4-path time-interleaved ADC;
- **figures 10a** and **10b** show a detailed block diagram of the circuit of fig.9, and
- **fig.11** shows a plot of the output Power Spectral Density (PSD) of the multi-path ADC of the present invention.

## DETAILED DESCRIPTION OF AN EMBODIMENT OF THE INVENTION

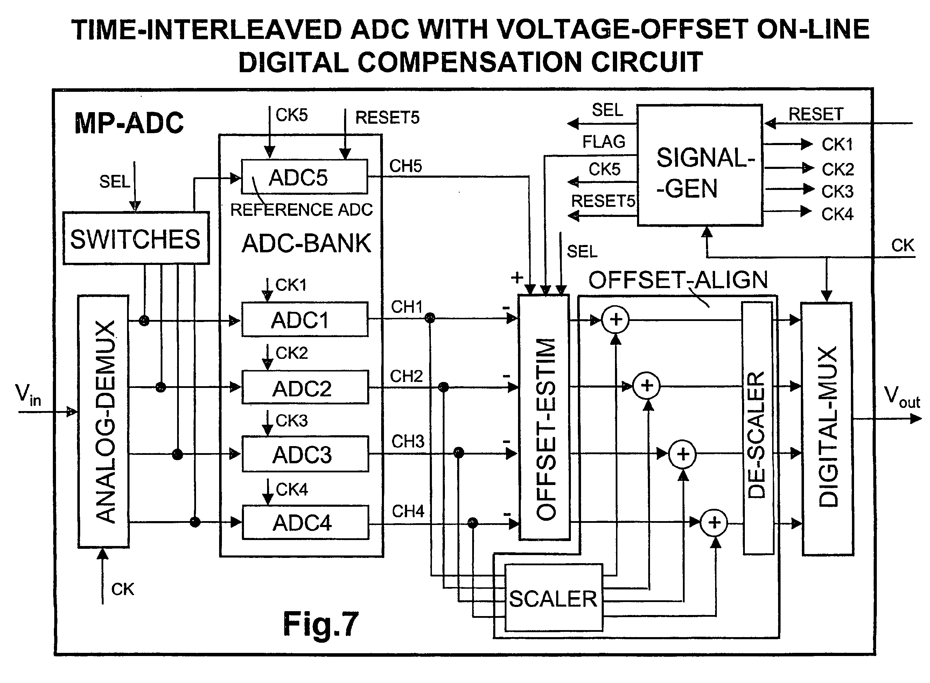

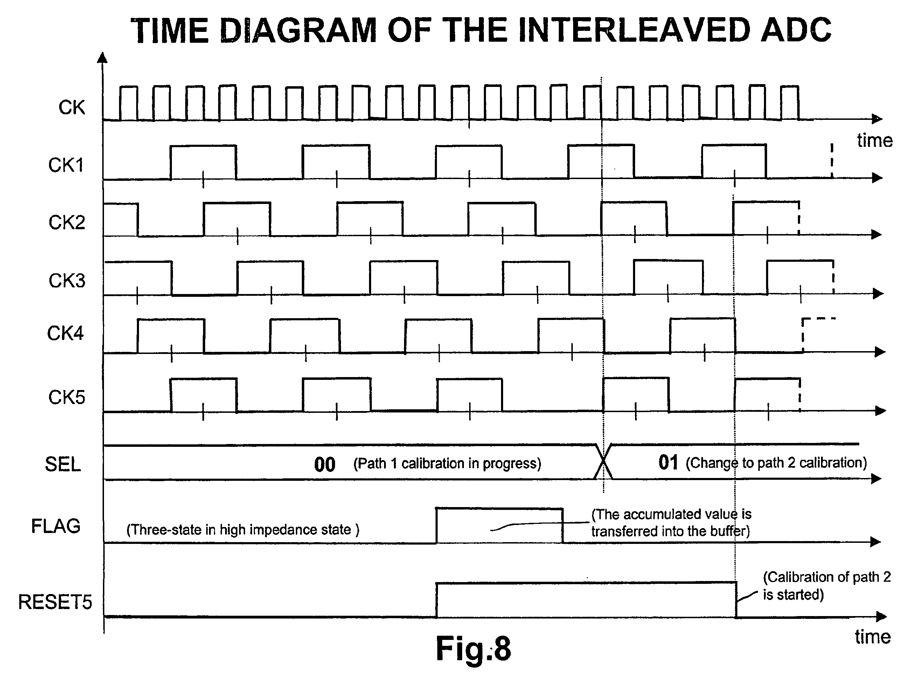

With reference to the **fig.7** it can be notice a general block diagram of a Multi-Path Analog-to-Digital Converter MP-ADC which includes the following blocks: ANALOG-DEMUX, SWITCHES, ADC-BANK, OFFSET-ESTIM, OFFSET-ALIGN, DIGITAL-MUX, and SIGNAL-GEN. Block ADC-BANK includes four Analog-to-Digital Converters ADC1 to ADC4 plus an additional reference ADC5 one. The A/D converters ADC1 to ADC5 can be of any type, in particular sigma-delta. Block OFFSET-ALIGN includes a SCALER, four two-input digital adders, and a DE-SCALER. The SIGNAL-GEN block receives a system clock CK and an external RESET and generates the following timing signals: CK1 to CK5, SEL, FLAG, and RESET5 directed to the other blocks as shown in the Figure to control their operation. The analog input signal $V_{in}$ which has to be digitally converted reaches the input of the analog demultiplexer ANALOG-DEMUX, whose four outputs are connected to the input of the four converters ADC1 to ADC4 inside the ADC-BANK and to the four inputs of the analog block SWITCHES. At the outputs of the converters ADC1 to ADC4 are in turn present four digital signals CH1 to CH4 directed to the inputs (-) of the digital OFFSET-ESTIM block. The unique output of the analog block SWITCHES is connected to the input of the fifth ADC5 converter whose digital output signal CH5 reaches the input (+) of the OFFSET-ESTIM block. The four outputs of the last block are connected to first inputs of four respective two-inputs digital adders included in the OFFSET-ALIGN block, while second inputs of the adders are connected to the outputs of the block SCALER which receives the CH1 to CH4 signals from the outputs of the ADC-BANK. The outputs of the four digital adders are connected to the inputs of the block DE-SCALER, whose outputs are connected to the inputs of the digital multiplexer DIGITAL-MUX that outputs the high-speed digitally converted signal $V_{out}$. Both ANALOG-DEMUX and DIGITAL-MUX are controlled by means of the CK clock. The block SIGNAL-GEN is implemented by means of a Finite-State-Machine (FSM) that generates the timing waveshapes visible in **fig.8**.

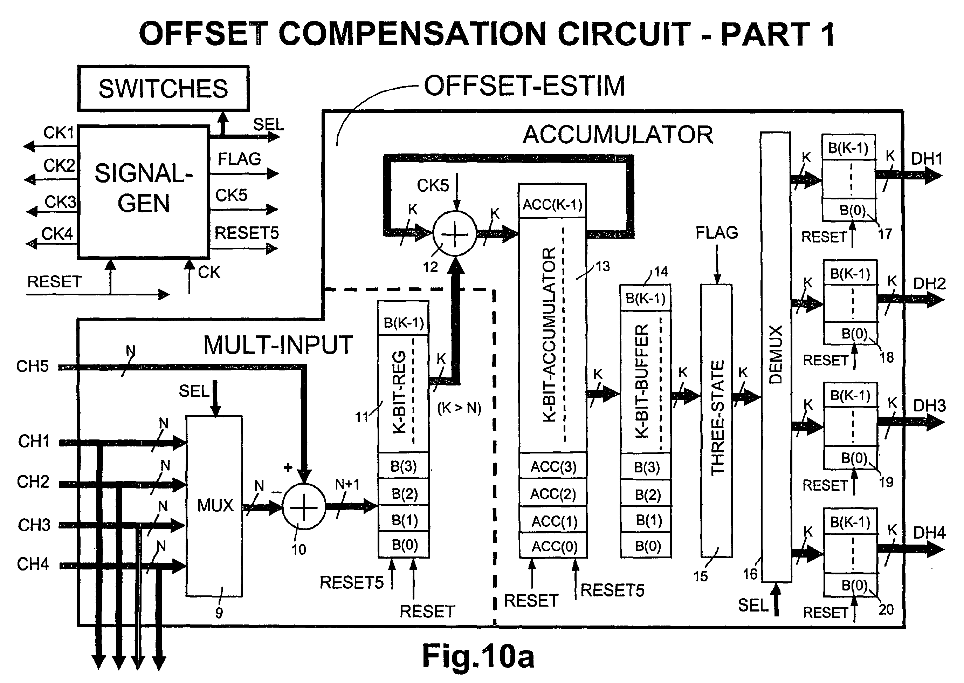

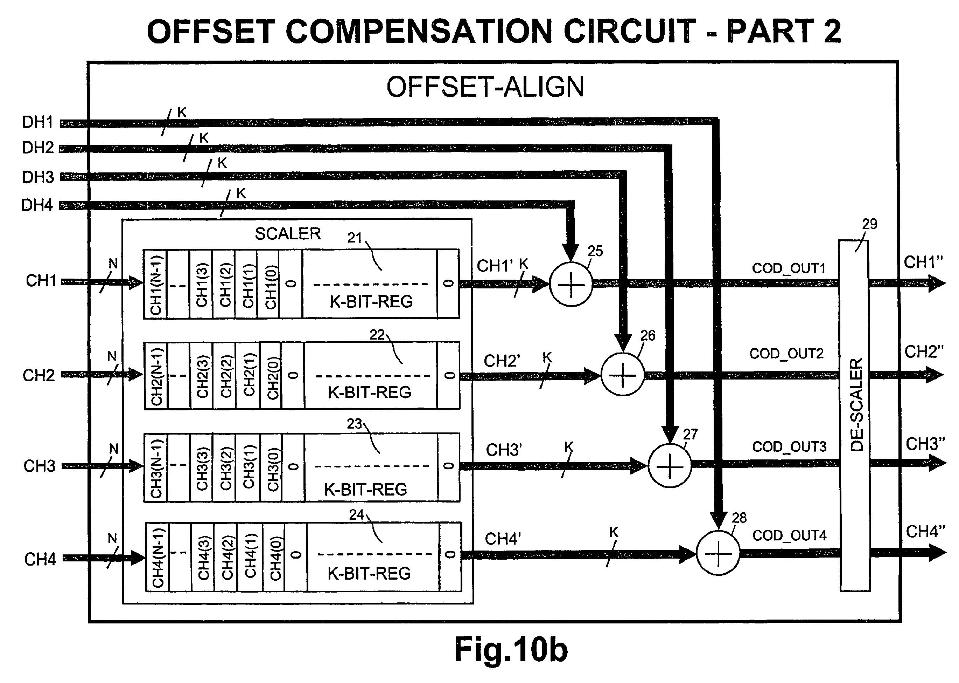

During operation, with reference to both the **Figures 7** and **8**, the analog demultiplexer ANALOG-DEMUX distributes with frequency $F_{CK}$ the analog input signal $V_{in}$ in turn to the ADC1 to ADC4 converters for the normal time-interleaved A/D conversion. The analog block SWITCHES is controlled by signal SEL to connect the one of the ADC1 to 4 converters to be calibrated in parallel to the additional ADC5 converter. Each of the ADC1 to ADC4 converters operates with a respective clock CK1 to CK4 at a frequency $F_{CK}/M$ (M = 4). In absence of any calibration activity the four outputs of the OFFSET-ESTIM block are all zero and at the four outputs of the OFFSET-ALIGN block there are the four uncalibrated time-interleaved digitally converted signals; these signals are multiplexed by DIGITAL-MUX block with frequency $F_{CK}$ to constitute the overall high-speed digitally converted signal $V_{out}$. The calibration procedure is started by the reset signal RESET5 directed to the ADC5 reference ADC. The reference path operates with a proper clock CK5 at a frequency $F_{CK}/M$, which is phase aligned to the clock signal of the path to be calibrated, as shown in fig.8. The differences between the outputs of these two paths are accumulated (integrated) over a given time slot TS by block OFFSET-ESTIM, thus producing a digital word equal to the difference between the accumulated offsets of the two paths while the signal components are cancelled. Block OFFSET-ALIGN adds up this word to the ADC output of the path under calibration opportunely multiplied by a scale factor which depends on the length of the given time slot, thus making the offset of the path under calibration dependent on the offset of the only reference path ADC5, as will be better described with reference to fig.10a. The words at the output of the relevant digital adder inside the block OFFSET-ALIGN are de-scaled by the same scale factor restoring the original converted value in which the contribute of the original voltage offset is replaced with the voltage offset of the reference path, as will be better described with reference to fig.10b. The procedure is indefinitely repeated for the M paths ADC1 to ADC4 of the ADC-BANK selected by a modulo-2 counting of the two bits SEL signal. After a reasonably time the voltage offset of each of the M paths is the same and is equally dependent on the offset of the reference path ADC5 (not necessarily zero), thus the high-speed digital signal $V_{out}$ can benefit of the advantages of calibration. If required, the offset of the reference path ADC5 can be periodically calibrated in order to make the offsets of all the paths equal to zero. To the limited extent of the calibration of the reference path well know techniques are available, for example, the method proposed in **[REF.18]** by T. H. Shu, B. S. Song, K. Bacrania, "A 13-b 10-Msample/s ADC Digitally Calibrated with Oversampling Delta-Sigma Converter", IEEE J. of Solid-State Circuits, Vol. SC-30, pp. 443-452, April 1995.

As far as concerns the duration of the compensation time slot TS, it can be considered that the SNR degradation in time-interleaved ADC is directly proportional to the variance $\delta_{off}$ of the offset mismatch. On the other hand, the duration of time slot TS influences the precision with which the offset correction is performed: the higher is TS the better is the SNR obtained with the same offset mismatch between the two paths. If the variance $\delta_{off}$ increases the time slot TS has to be increased. Depending on the variance $\delta_{off}$ and on the required offset compensation, an optimum value for TS and for the number of bit in the digital offset estimation is determined. In principle, the offset to be compensated can be allowed to be large without effect on the SNR of the output signal $V_{out}$. Since the block OFFSET-ESTIM produces a digital word proportional to the only difference between the offsets of the two (in turn) compared paths, while the input signal components are completely cancelled, the input signal $V_{in}$ can have any frequency components, including those located around $F_{CK}/M$, thus overcoming the limits of the method reported in **[REF.12].** Moreover, since the calibration signal does not interfere with the wanted signal the full-scale range of the various ADCs is available for the input signal. Finally, since the proposed calibration technique is purely digital, it does not operate on any analog section of the ADCs and is essentially applied at the output. Therefore, it is intrinsically robust and does not exhibit the critical issues of the method reported in **[REF.15]**.

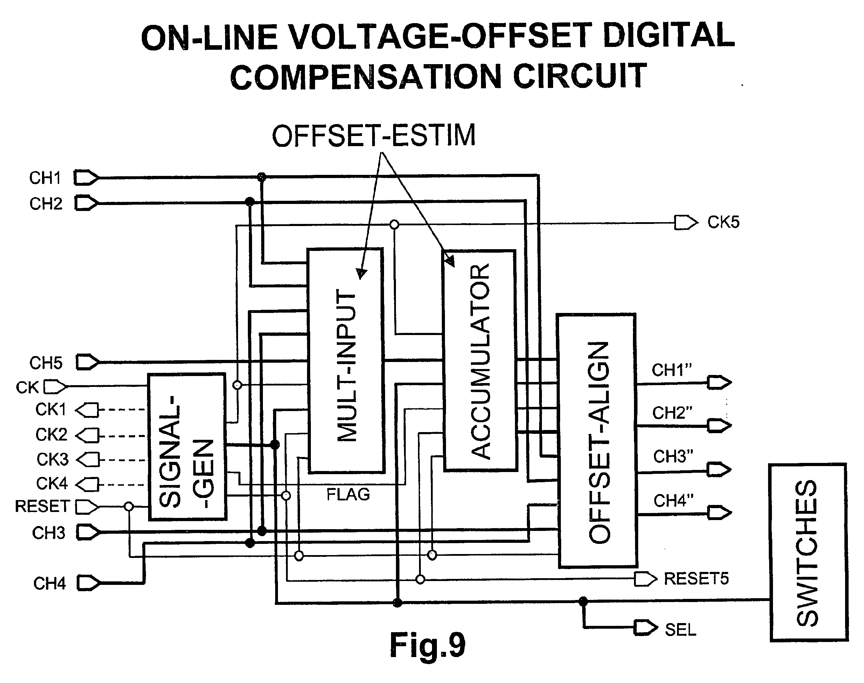

With reference to **fig.9** a block diagram of the only voltage offset compensation circuit belonging to the multi-path ADC of the previous **fig.7** is shown. Elements and signals equal in the two Figures are equally labelled. The voltage offset compensation circuit visible in the previous fig.7 included the following blocks: SWITCHES, OFFSET-ESTIM, and OFFSET-ALIGN; block SIGNAL-GEN reasonably belongs both to the multi-path ADC for the generation of CK1 to CK4 clocks (which time the normal operation even without compensation) and to the compensation circuit for the generation of the remaining timing signals: SEL, CK5, RESET5, and FLAG. The compensation circuit of **fig.9** is more detailed than the one coarsely indicated in fig.7 and two new blocks MULT-INPUT and ACCUMULATOR replace the previous blocks OFFSET-ESTIM. Block MULT-INPUT receives the signal CH1 to CH4 from the ADC1 to 4 to be calibrated and signal CH5 from the reference ADC5. The digital output of block MULT-INPUT is connected to the input of the cascaded block ACCUMULATOR for delivering the calculated differences. Block ACCUMULATOR receives the difference values and integrates them over a given time slot TS, obtaining integration data forwarded to the four inputs of the cascaded block OFFSET-ALIGN. This last block compensates the estimated voltage offset of the four CH1 to 4 digital signals, as already said, and outputs four compensated words CH1", CH2", CH3", and CH4" directed to the cascaded block DIGITAL-MUX belonging to the multi-path ADC (fig.7). An external signal RESET is directed to all the blocks visible in fig.9 (SIGNAL-GEN included) for the correct initialisation of the operation. The timing signals SEL, RESET5 and CK5 are addressed both to the MULT-INPUT and ACCUMULATOR blocks, while FLAG is directed to the only ACCUMULATOR block.

In operation, block SWITCHES implements the connection of the additional reference ADC5 in parallel to the one of the ADC1 to 4 converters to be calibrated selected by signal SEL. Block MULT-INPUT performs the difference between the outputs of these two paths and delivers it to the block ACCUMULATOR. Block ACCUMULATOR receives the differences between the output signal of the reference path ADC5 and of the path under calibration and integrates them over a given time slot TS. Signal FLAG directed to the block ACCUMULATOR detects when the averaging phase is terminated and the result can be delivered to an internal output buffer (not visible in fig.8). Finally, signal SEL performs the multiplexing of the outputs, which are the offset estimation of the four interleaved ADCs, to the proper channel.

**Figures 10a** and **10b** show with greater detail the device of the preceding fig.9 in order to point out the internal structure of the various registers and the dimension of the relevant buses. With reference to **fig.10a** the block MULT-INPUT is implemented by means of a digital multiplexer MUX 9 driven by the 2-bit SEL signal, which sequentially selects one of the N-bit (including the sign) digital signals CH1 to 4 of the paths to be calibrated. Moreover, it includes a subtractor 10 that calculates the algebraic difference between the N-bit reference signal CH5 and the selected signal. Finally, a register K-BIT-REG 11 transforms the word at the output of the subtractor 10 into a K-bit word (K > N) to be sent to the block ACCUMULATOR. The block ACCUMULATOR includes the following blocks: a digital adder 12, a register K-BIT-ACCUMULATOR 13, a buffer register K-BIT-BUFFER 14, a three state buffer THREE-STATE 15, a digital demultiplexer DEMUX 16, and four K-bit registers 17, 18, 19, and 20. The output of block 13 is fed into the K-BIT-BUFFER 14, which is isolated from the input of demultiplexer DEMUX 16 by the THREE-STATE interface 15 placed in-between. Three-state 15 is put in high impedance state when the accumulator 13 is working. At the end of the integration time slot TS the assertion of the signal FLAG enable the three-state to forward the result of the offset accumulation to the input of the demultiplexer DEMUX 16 which transfers it, depending on the signal SEL, to the proper output connected to one of the four K-bit registers 17 to 20. While circuits preceding the demultiplexer DEMUX 16 is shared among the various channels CH1 to CH4, the successive circuits are dedicated; these last include registers 17 to 20, whose K-bit outputs are indicated with DH1, DH2, DH3, and DH4. The value in turn stored in the selected register at the output of DEMUX 16 remains stable until the next value is overwritten (at the begin of TS+4 integration time slot) to allow voltage offset compensation with an updated offset value. The compensation task is charged to the OFFSET-ALIGN block of the next Figure. With reference to **fig.10b** the OFFSET-ALIGN block includes: the block SCALER, in its turn comprising four registers K-BIT-REG 21 to 24, four digital adders 25 to 28, and the block DE-SCALER 29. The N-bit signals CH1 to CH4 reach the input of the K-BIT-REG 21 to 24 at whose outputs are present corresponding K-bit signals CH1', CH2', CH3', and CH4'. These K-bit signals reach first inputs of digital adders 25 to 28, whose second inputs are reached by the K-bit differences DH1 to DH4 (fig.10a). At the outputs of the four digital adders 25 to 28 are present four digital words COD_OUT1, COD_OUT2, COD_OUT3, and COD_OUT4. These words are directed to the four inputs of the block SCALER which outputs four de-scaled signal CH1 ", CH2", CH3", and CH4".

In operation, with further reference to the preceding **fig.8**, the various time signals start by indicating path 1 calibration in progress, namely signal SEL = 00 and the clocks CK1 and CK5 in phase. With this position a K-bit word from the K-BIT-REG 11 reaches at the actual time T a first input of the digital adder 12, whose second input is fed with a T-1 output word sent back from the output of the block 13; the result of the sum at time T is introduced again into the accumulator 13, and so on for all the duration of the integration time slot TS relevant to the current calibration path. The assertion of the signal FLAG determines the end of the actual integration time slot TS and the transfer of the accumulated word DH1 from buffer 14 to the register 17 which stores it. Simultaneously to the assertion of the signal FLAG the signal RESET5 is also asserted for resetting the reference path, namely the K-bit register 11 and the accumulator 13. As soon as signal FLAG is negated the signal SEL changes from the previous configuration 00 to 01 for the selection of the second path CH2 at the input of the digital MUX 9 (and DEMUX 16). Contextually with the change of the signal FLAG the clock CK5 is synchronized with clock CK2, and when also the signal RESET5 is negated, the calibration of path2 is started. The calibration is started by signal RESET that zeroes the output of the addressed blocks.

Registers K-BIT-REG 11 and K-BIT-REG 21 to 24 accept N-bit input words and output K-bit words with K > N. The number of bits K has to be large enough to allow the correction of the offset with the required degree of precision and over a defined time slot TS. The conversion from N to K bits takes place with known methods, for example with the repetition of the sign bit in K-BIT-REG 11 and filling up with zeros the K - N least significant positions in K-BIT-REG registers 21 to 24. The same filling rule valid for K-BIT-REG 11 is also valid for the K-bit registers 14, 17, 18, 19, and 20. In that a digital number is written in said registers as usual, while a digital number written in the K-bit registers 21 to 24 is shifted left in the most significant K - N positions, as known this is equivalent to multiply the number by the scale factor $2^{(K-N)}$. Block DE-SCALER includes four K-bit registers (not shown for brevity) which receive the COD_OUT1 to COD_OUT4 words and perform a shift right of K - N positions discarding the most significant K - N bits, as known this is equivalent to divide the number by $2^{(K-N)}$.

The following arguments better illustrate the behaviour of the multi-path ADC of the present invention from the theoretical point of view.

Let us suppose to have to calibrate the converter ADC1 using the reference converter ADC5 in parallel. At the input of the accumulator 13 there are the sample of the two signals CH1 and CH5 (represented with K bits):

$$ACC\_IN(i) = offset_5(i) + signal_5(i) - offset_1(i) - signal_1(i) \qquad (E5)$$

where i is the i-th sample ranging from 1 to Y, being Y the total number of samples, which is a power of two, considered in the time slot TS. The accumulator 13 carries out the following offset difference estimate DH1:

$$DH1 = \left( \sum_{i=1}^{Y} offset_5(i) - offset_1(i) \right) + \left( \sum_{i=1}^{Y} signal_5(i) - signal_1(i) \right) \qquad (E6)$$

The accumulator is K-bit long and is filled starting from LSB (Least Significant Bit). Being the offset variations with temperature or ageing over time noticeable slow, the offset is assumed constant during the accumulation time slot TS, while the signal is varying, it can be held:

$$DH1 = Y \times \left( offset_5 - offset_1 \right) + \left( \sum_{i=1}^{Y} signal_5(i) - signal_1(i) \right) \qquad (E7)$$

The expression:

$$\left( \sum_{i=1}^{Y} signal_5(i) - signal_1(i) \right) \qquad (E8)$$

would be identically null for a conventional ADC without memory, such as a pipelined, considering that the same signal is applied contemporarily to both the reference ADC5 and the calibrated ADC1 converters, while for a sigma-delta could be not because an output sample at time T depends on the previous samples at time T-1, T-2,..., etc. More precisely, the difference (E8) would be absolutely zero for the low frequency components (including DC), while it should be slightly different from zero for the high frequency components, where the majority of the quantization noise is shifted. Nevertheless the average over the long period of the difference (E8) tends to zero. Therefore with a suitable value of time slot TS:

$$DH1_{TS \to \infty} = Y \times \left( offset_5 - offset_1 \right) . \qquad (E9)$$

At the end of the accumulation the K-bit estimate (E9) is transferred to the buffer 14 and the to DEMUX 16. Contemporarily the N-bit digital word CH1 is transformed in the K-bit word CH1', where the N bits are put in the most significant positions:

$$CH1' = Y \times (offset_1 + signal_1) \tag{E10}$$

At the output of digital adder 25 there is the following signal COD_OUT1:

$$COD\_OUT1 = Y \times (offset_1 + signal_1) + Y \times (offset_5 - offset_1)$$
$$= Y \times (signal_1 + offset_5) \tag{E11}$$

Word COD_OUT1 is still K bits and contains the wished signal plus the offset of the reference path both multiplied by the scale factor $Y = 2^{(K-N)}$. The presence of block DE-SCALER for dividing COD_OUT1 by the scale factor Y is optional; in fact the word COD_OUT1 can be used directly by the downstream microprocessor, provided that it considers the scaling operation as done, and gives to the various bits the right weight. For example: 4 bit → 1101 configuration corresponds to an analog value:

$$V_{analog} = (2^0 + 2^2 + 2^3) \times \frac{DR}{2^4} = \frac{13}{16} \times DR \tag{E12}$$

where DR is the dynamic range of the single ADC. Supposing DR = 1 V, it will be: $V_{analog}$ = 0.8125 V. In this case the weight of the Most Significant Bit (MSB), which is the most left bit, is DR/2 = 0.5 V. Now the above 4-bit configuration is transformed to 10 bits by the insertion of the original 4 bits in a register, starting from the MSB: the resulting 10 bit configuration → 1101000000 corresponds to a value:

$$V_{analog} = (2^6 + 2^8 + 2^9) \times \frac{DR}{2^{10}} = \frac{832}{1024} \times DR \tag{E13}$$

which is again 0.8125 V. Even in this case the MSB weight is DR/2 = 0.5 V. It can be argued that either considering or not considering the scale factor Y the voltage offset of path ADC1 is forced to be equal to the voltage offset of the reference path ADC5 that is true for all the remaining paths.

In a second embodiment of the invention the average of the differences is performed instead of the simpler accumulation performed in the first embodiment, consequently the two blocks SCALER and DE-SCALER are unnecessary and the block OFFSET-ESTIM carries out the following average operation:

$$DH1 = \frac{\left(\sum_{i=1}^{Y} offset_5(i) - offset_1(i)\right)}{Y} + \frac{\left(\sum_{i=1}^{Y} signal_5(i) - signal_1(i)\right)}{Y} \tag{E14}$$

to say:

$$DH1 = \left(offset_5 - offset_1\right) + \frac{\left(\sum_{i=1}^{Y} signal_5(i) - signal_1(i)\right)}{Y} \qquad (E15)$$

and then:

$$DH1_{TS \to \infty} = \left(offset_5 - offset_1\right) \qquad (E16)$$

which corresponds to the (E9) divided by the scale factor Y. Contemporarily the N-bit digital word CH1 is transformed in the K-bit word CH1', but in this second embodiment the N bits are put in the least significant positions, instead of the most significant positions performed in the first embodiment, so that:

$$CH1' = \left(offset_1 + signal_1\right) \qquad (E17)$$

At the output of digital adder 25 there is the following signal COD_OUT1:

$$COD\_OUT1 = \left(offset_1 + signal_1\right) + \left(offset_5 - offset_1\right)$$
$$= \left(signal_1 + offset_5\right) \qquad (E18)$$

In that the voltage offset of path ADC1 is forced to be equal to the voltage offset of the reference path ADC5. Word COD_OUT1 is still K bits and contains the wanted signal plus the offset of the reference path. The hardware implementation of a compensation circuit based on the average is slight more complicated than the one based on the accumulation and subsequent use of the scale factor, but the skill in compensation is the same.

Independently from one or the other embodiment, the dimension of the K-bit accumulator 13 avails of the following considerations. The number Y of the samples taken in a time slot TS is a power of 2. The value K shall be at mimimum as that: $2^K = Y$. Considering the worst case in which all the samples of CH5 give a positive contribution to the DH1 word and all the samples of CH1 give a negative contribution to the DH1 word, at the end the accumulator register 13 will contain a digital word representing the value

$$DH1 = Y \cdot \left(2 \cdot \sum_{i=0}^{N-2} 2^i\right) \qquad (E19)$$

(that is also true for DH2, DH3 and DH4). As known a K-bit register with sign containing 1 in all positions is able to represent at most $(2^K - 1)$ values. From here the utility to have:

$$2^K - 1 \geq Y \cdot \left(2 \cdot \sum_{i=0}^{N-2} 2^i\right) \qquad (E20)$$

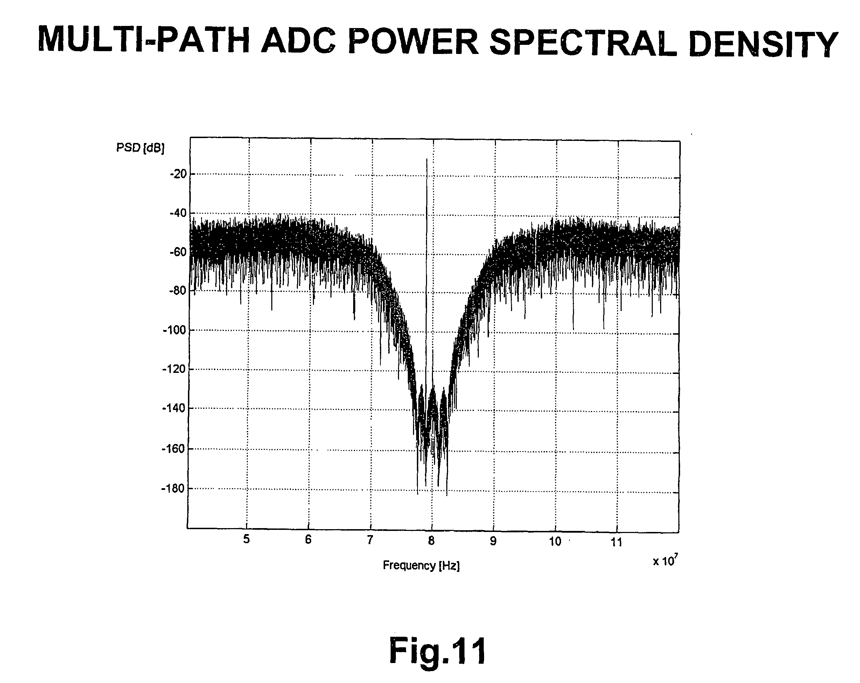

to compensate the strict requirements on the voltage offset. That is true for all types of ADCs. Furthermore for the only sigma-delta converter the in-band punctual quantization noise is very low, as shown in **fig.11**, much less than the wished resolution, which instead depends on the integration of the quantization noise over the useful band. In conclusion the digital "granularity" of the compensation circuit shall be equal at least at the one required in band. In the case of **fig.11** the granularity is about - 130 dB corresponding to $2^{22}$. In that K = 22 bit.

The main technical characteristics of a multi-path ADC of the two embodiments of the invention are the following:

Number of paths = 4;
Equivalent sample frequency $F_{CK}$ = 320 MHz;
Individual sample frequency of each path = 80 MHz;
Transfer function = band-pass around 80 MHz (as shown in **fig.11**);
Bandwidth of the band-pass channel = 5 MHz;
Oversampling Ratio OSR = 32;
Dynamic level of the differential input signal Vin = 1 Vpp;
Number of the equivalent bits = 15 bits;
Number of samples considered in an accumulation Time Slot TS = 131072 ($2^{17}$);
Time Slot duration for a single path = 1.6384 ms;
Number of bits of the accumulator register 13 = 22 bits.

**Fig.11** shows a plot of the Power Spectral Density (PSD) of a multi-path ADC of the two embodiments of the invention. With reference to **Fig.11** the Signal-to-Noise Ratio (SNR) calculated from the PSD function on the 5 MHz band is equal to 93.8 dB. This value corresponds to 15.29 equivalent bits of resolution from the formula:

$$SNR(dB) = 6.02 \cdot N_{bit} + 1.76. \qquad (E21)$$

The input signal corresponds to the longer line which appears in the proximity of 79 MHz, while the other smaller line at 80 MHz having amplitude of near -110 dB, is due to the residual mismatch among the voltage offsets of the various paths. Increasing the length of the accumulation timeslot TS and the number K of bits considered in the differences can reduce the latter. The level of the residual offset in Figure is very low indeed, sufficiently below the requirements of a modem BTS. Without offset compensation, the residual mismatch line at 80 MHz in fig.11 should be - 42 dB, and the SNR should be worsened remarkably. The Power Spectral Density of fig.11 has been obtained by computer simulation and confirmed by measures carried out on a prototype. In the simulation the offsets taken for the various paths are:

$CH1_{Voffset} \rightarrow$ -0.00250974 V
$CH2_{Voffset} \rightarrow$ -0.0122784 V
$CH3_{Voffset} \rightarrow$ 0.00250588 V
$CH4_{Voffset} \rightarrow$ 0.00301679 V
$CH5_{Voffset} \rightarrow$ 0.00199551 V

In that the initial offset mismatch among the various paths is taken sufficiently high. In spite of that at the end of the compensation task the various offsets have been made coincide to the offset of the reference channel CH5 for less than the allowed 22 bit precision.

In conclusion, the use of the on-line digital calibration technique in any type of ADC, especially sigma-delta converters, represents an improvement compared to previous implementations, since it enables to increase the performance of these circuits in terms of speed, while maintaining or improving accuracy.

**Claims**

1. Method for compensating the voltage offset of each analog-to-digital converter component part of a multi-path time-interleaved analog-to-digital converter (MP-ADC) which exploits an additional analog-to-digital converter (ADC5) as reference, **characterised in that** it is based on the following steps cyclically repeated for each of the analog-to-digital converter component parts (ADC1, ADC2, ADC3, ADC4) under calibration:

- connecting the reference analog-to-digital converter (ADC5) in parallel to a selected analog-to-digital converter component part (ADC1, ADC2, ADC3, ADC4) and synchronising to each other;
- calculating the algebraic differences between first digital words (CH5) at the output of the reference analog-to-digital converter (ADC5) and second corresponding digital words (CH1, CH2, CH3, CH4) at the output of the selected analog-to-digital converter component part (ADC1, ADC2, ADC3, ADC4) and accumulating the differences over a given time slot thus obtaining a third digital word (DH1, DH2, DH3, DH4);

- adding the third digital word (DH1, DH2, DH3, DH4) to the output signal (CH1', CH2', CH3', CH4') of the selected analog-to-digital converter multiplied by a scale factor which depends on the length of the given time slot, obtaining fourth digital words (COD_OUT1, COD_OUT2, COD_OUT3, COD_OUT4) proportional to the sum of said output signal (CH1', CH2', CH3', CH4') with the voltage offset of the reference analog-to-digital converter (ADC5) and totally deprived of the original voltage offset.

2. Method for compensating the voltage offset of each analog-to-digital converter component part of a multi-path time-interleaved analog-to-digital converter (MP-ADC) which exploits an additional analog-to-digital converter (ADC5) for reference, **characterised in that** it is based on the following steps cyclically repeated for each of the analog-to-digital converter component part (ADC1, ADC2, ADC3, ADC4) under calibration:

- connecting the reference analog-to-digital converter (ADC5) in parallel to a selected analog-to-digital converter component part (ADC1, ADC2, ADC3, ADC4) and synchronising each other;
- calculating the algebraic differences between first digital words (CH5) at the output of the reference analog-to-digital converter (ADC5) and second corresponding digital words (CH1, CH2, CH3, CH4) at the output of the selected analog-to-digital converter component part (ADC1, ADC2, ADC3, ADC4) and averaging the differences over a given time slot thus obtaining a third digital word (DH1, DH2, DH3, DH4);
- adding the third digital word (DH1, DH2, DH3, DH4) to the output signal (CH1', CH2', CH3', CH4') of the selected analog-to-digital converter obtaining fourth digital words (COD_OUT1, COD_OUT2, COD_OUT3, COD_OUT4) representing said output signal (CH1', CH2', CH3', CH4') deprived of the original offset and including the offset of the only reference analog-to-digital converter (ADC5).

3. Method in accordance with claim 1 or 2, **characterised in that** said first (CH5) and second (CH1, CH2, CH3, CH4) digital words are N-bit long, while said third digital word (DH1, DH2, DH3, DH4) is K-bit long, being K > N large enough to allow the compensation of the voltage offset with the required degree of precision and over the accumulation time slot.

4. Method in accordance with claim 3 depending on claim 1, **characterised in that** said scale factor is equal to $2^{(K-N)}$.

5. Method in accordance with the preceding claim, **characterised in that** said fourth digital words (COD_OUT1, COD_OUT2, COD_OUT3, COD_OUT4) are divided by said scale factor obtaining fifth digital words (CH1", CH2", CH3", CH4") restoring the original converted value.

6. Voltage offset compensation circuit for the connection to a multi-path time-interleaved analog-to-digital converter (MP-ADC) having an additional analog-to-digital converter (ADC5) for reference, **characterised in that** it includes:

- means (SWITCHES) for connecting the reference analog-to-digital converter (ADC5) in parallel to a selected analog-to-digital converter component part (ADC1) and synchronising each other;
- means (MUX) for selecting the output signal of an analog-to-digital converter component part to be calibrated (ADC1, ADC2, ADC3, ADC4);
- means (10) for calculating the algebraic differences between first digital words (CH5) at the output of the reference analog-to-digital converter (ADC5) and second corresponding digital words (CH1, CH2, CH3, CH4) at the output of the selected analog-to-digital converter component part;
- means (ACCUMULATOR) for accumulating the calculated differences over a given time slot, thus obtaining a third digital word (DH1, DH2, DH3, DH4);
- means (OFFSET-ALIGN) for adding the third digital word (DH1, DH2, DH3, DH4) to the output signal (CH1', CH2', CH3', CH4') of the selected analog-to-digital converter multiplied by a scale factor which depends on the length of the given time slot, obtaining fourth digital words (COD_OUT1, COD_OUT2, COD_OUT3, COD_OUT4) proportional to the sum of said output signal (CH1', CH2', CH3', CH4') with the voltage offset of the reference analog-to-digital converter (ADC5) and totally deprived of the original voltage offset.

7. Voltage offset compensation circuit in accordance with the preceding claim, **characterised in that** includes:

- first register means (11) for transforming said differences N-bit long into differences K-bit long inputted to said accumulation means (ACCUMULATOR), being K > N large enough to allow the compensation of the voltage offset with the required degree of precision and over the given time slot;
- second register means (21, 22, 23, 24) for transforming said second digital word (CH1, CH2, CH3, CH4) N-bit long into a corresponding digital word K-bit long (CH1', CH2', CH3', CH4')
- third register means (DE-SCALER) for transforming said fourth digital words (COD_OUT1, COD_OUT2, COD_OUT3, COD_OUT4) K-bit long into fifth digital words (CH1", CH2", CH3", CH4") restoring the original converted value.

8. Multi-path time-interleaved analog-to-digital converter (MP-ADC) exploiting an additional reference analog-to-digital converter (ADC5) including:

- means (ANALOG-DEMUX) for cyclically demultiplexing the analog input signal ($V_{in}$) to the analog-to-digital converter component parts (ADC1, ADC2, ADC3, ADC4);
- means (DIGITAL-DEMUX) for cyclically multiplexing digital signals (COD_OUT1, COD_OUT2, COD_OUT3, COD_OUT 4) at the output of said analog-to-digital converter component parts (ADC1, ADC2, ADC3, ADC4), obtaining an unique digital output signal ($V_{out}$);

**characterised in that**, further includes:

- means (SWITCHES) for connecting the reference analog-to-digital converter (ADC5) in parallel to a selected analog-to-digital converter component part (ADC1) and synchronising each other;
- means (MUX) for selecting the output signal of an analog-to-digital converter component part to be calibrated (ADC1, ADC2, ADC3, ADC4);
- means (10) for calculating the algebraic difference between first digital words (CH5) at the output of the reference analog-to-digital converter (ADC5) and second corresponding digital words (CH1, CH2, CH3, CH4) at the output of the selected analog-to-digital converter component part;
- means (ACCUMULATOR) for accumulating the calculated differences over a given time slot, thus obtaining a third digital word (DH1, DH2, DH3, DH4);
- means (OFFSET-ALIGN) for adding the third digital word (DH1, DH2, DH3, DH4) to the output signal (CH1', CH2', CH3', CH4') of the selected analog-to-digital converter multiplied by a scale factor which depends on the length of the given time slot, obtaining fourth digital words (COD_OUT1, COD_OUT2, COD_OUT3, COD_OUT4) proportional to the sum of said output signal (CH1', CH2', CH3', CH4') with the voltage offset of the reference analog-to-digital converter (ADC5) and totally deprived of the original voltage offset.

9. Multi-path time-interleaved analog-to-digital converter (MP-ADC) in accordance with the preceeding claim, **characterised in that** said analog-to-digital converter component parts (ADC1, ADC2, ADC3, ADC4) are of the sigma-delta type.

### Patentansprüche

1. Verfahren zum Kompensieren der Offsetspannung jedes Analog-Digital-Wandlers, der Bestandteil eines zeitverschachtelten Mehrwege-Analog-Digital-Wandlers (MP-ADC) ist, der einen zusätzlichen Analog-Digital-Wandler (ADC5) als Referenz benutzt, **dadurch gekennzeichnet, dass** es auf den folgenden Schritten beruht, die für jeden der Bestandteile darstellenden Analog-Digital-Wandler (ADC1, ADC2, ADC3, ADC4), der zu kalibrieren ist, zyklisch wiederholt werden:

- Parallelschalten des Referenz-Analog-Digital-Wandlers (ADC5) zu einem ausgewählten, einen Bestandteil darstellenden Analog-Digital-Wandler (ADC1, ADC2, ADC3, ADC4) und Synchronisieren miteinander;
- Berechnen der algebraischen Differenzen zwischen ersten digitalen Wörtern (CH5) am Ausgang des Referenz-Analog-Digital-Wandlers (ADC5) und zweiten entsprechenden digitalen Wörtern (CH1, CH2, CH3, CH4) am Ausgang des ausgewählten, einen Bestandteil darstellenden Analog-Digital-Wandlers (ADC1, ADC2, ADC3, ADC4) und Akkumulieren der Differenzen über einen gegebenen Timeslot, so dass ein drittes digitales Wort (DH1, DH2, DH3, DH4) erhalten wird;
- Addieren des dritten digitalen Worts (DH1, DH2, DH3, DH4) zu dem Ausgangssignal (CH1', CH2', CH3', CH4') des ausgewählten Analog-Digital-Wandlers, das mit einem Skalierungsfaktor multipliziert wurde, der von der Länge des gegebenen Timeslots abhängt, so dass vierte digitale Wörter (COD_OUT1, COD_OUT2, COD_OUT3, COD_OUT4) erhalten werden, die zu der Summe des besagten Ausgangssignals (CH1', CH2', CH3', CH4') und der Offsetspannung des Referenz-Analog-Digital-Wandlers (ADC5) proportional sind und aus denen die ursprüngliche Offsetspannung vollständig eliminiert ist.

2. Verfahren zum Kompensieren der Offsetspannung jedes Analog-Digital-Wandlers, der Bestandteil eines zeitverschachtelten Mehrwege-Analog-Digital-Wandlers (MP-ADC) ist, der einen zusätzlichen Analog-Digital-Wandler (ADC5) als Referenz benutzt, **dadurch gekennzeichnet, dass** es auf den folgenden Schritten beruht, die für jeden der Bestandteile darstellenden Analog-Digital-Wandler (ADC1, ADC2, ADC3, ADC4), der zu kalibrieren ist, zyklisch wiederholt werden:

- Parallelschalten des Referenz-Analog-Digital-Wandlers (ADC5) zu einem ausgewählten, einen Bestandteil darstellenden Analog-Digital-Wandler (ADC1, ADC2, ADC3, ADC4) und Synchronisieren miteinander;
- Berechnen der algebraischen Differenzen zwischen ersten digitalen Wörtern (CH5) am Ausgang des Referenz-Analog-Digital-Wandlers (ADC5) und zweiten entsprechenden digitalen Wörtern (CH1, CH2, CH3, CH4) am Ausgang des ausgewählten, einen Bestandteil darstellenden Analog-Digital-Wandlers (ADC1, ADC2, ADC3, ADC4) und Mitteln der Differenzen über einen gegebenen Timeslot, so dass ein drittes digitales Wort (DH1, DH2, DH3, DH4) erhalten wird;
- Addieren des dritten digitalen Worts (DH1, DH2, DH3, DH4) zu dem Ausgangssignal (CH1', CH2', CH3', CH4') des ausgewählten Analog-Digital-Wandlers, so dass vierte digitale Wörter (COD_OUT1, COD_OUT2, COD_OUT3, COD_OUT4) erhalten werden, die das besagte Ausgangssignal (CH1', CH2', CH3', CH4') repräsentieren, aus dem der ursprüngliche Offset eliminiert wurde und das den Offset des einzigen Referenz-Analog-Digital-Wandlers (ADC5) enthält.

3. Verfahren nach Anspruch 1 oder 2, **dadurch gekennzeichnet, dass** die besagten ersten (CH5) und zweiten (CH1, CH2, CH3, CH4) digitalen Wörter eine Länge von N Bits haben, während das besagte dritte digitale Wort (DH1, DH2, DH3, DH4) eine Länge von K Bits hat, wobei K > N genügend groß ist, um die Kompensation der Offsetspannung mit dem geforderten Genauigkeitsgrad und über den Akkumulations-Timeslot zu ermöglichen.

4. Verfahren nach Anspruch 3, sofern dieser von Anspruch 1 abhängt, **dadurch gekennzeichnet, dass** der besagte Skalierungsfaktor gleich $2^{(K-N)}$ ist.

5. Verfahren nach dem vorhergehenden Anspruch, **dadurch gekennzeichnet, dass** die besagten vierten digitalen Wörter (COD_OUT1, COD_OUT2, COD_OUT3, COD_OUT4) durch den besagten Skalierungsfaktor dividiert werden, so dass fünfte digitale Wörter (CH1",CH2", CH3", CH4") erhalten werden, die den ursprünglichen gewandelten Wert wiederherstellen.

6. Offsetspannungskompensationsschaltung für den Anschluss an einen zeitverschachtelten Mehrwege-Analog-Digital-Wandler (MP-ADC), der einen zusätzlichen Analog-Digital-Wandler (ADC5) als Referenz aufweist, **dadurch gekennzeichnet, dass** sie enthält:

- Mittel (SWITCHES) zum Parallelschalten des Referenz-Analog-Digital-Wandlers (ADC5) zu einem ausgewählten, einen Bestandteil darstellenden Analog-Digital-Wandler (ADC1) und Synchronisieren miteinander;
- Mittel (MUX) zum Auswählen des Ausgangssignals eines zu kalibrierenden, einen Bestandteil darstellenden Analog-Digital-Wandlers (ADC1, ADC2, ADC3, ADC4);
- Mittel (10) zum Berechnen der algebraischen Differenzen zwischen ersten digitalen Wörtern (CH5) am Ausgang des Referenz-Analog-Digital-Wandlers (ADC5) und zweiten entsprechenden digitalen Wörtern (CH1, CH2, CH3, CH4) am Ausgang des ausgewählten, einen Bestandteil darstellenden Analog-Digital-Wandlers;
- Mittel (AKKUMULATOR) zum Akkumulieren der berechneten Differenzen über einen gegebenen Timeslot, so dass ein drittes digitales Wort (DH1, DH2, DH3, DH4) erhalten wird;
- Mittel (OFFSET-ALIGN) zum Addieren des dritten digitalen Worts (DH1, DH2, DH3, DH4) zu dem Ausgangssignal (CH1', CH2', CH3', CH4') des ausgewählten Analog-Digital-Wandlers, das mit einem Skalierungsfaktor multipliziert wurde, der von der Länge des gegebenen Timeslots abhängt, so dass vierte digitale Wörter (COD_OUT1, COD_OUT2, COD_OUT3, COD_OUT4) erhalten werden, die zu der Summe des besagten Ausgangssignals (CH1', CH2', CH3', CH4') und der Offsetspannung des Referenz-Analog-Digital-Wandlers (ADC5) proportional sind und aus denen die ursprüngliche Offsetspannung vollständig eliminiert ist.

7. Offsetspannungskompensationsschaltung nach dem vorhergehenden Anspruch, **dadurch gekennzeichnet, dass** sie enthält:

- erste Registermittel (11) zum Transformieren der besagten Differenzen mit einer Länge von N Bits in Differenzen mit einer Länge von K Bits, die in die besagten Akkumulationsmittel (AKKUMULATOR) eingegeben werden, wobei K > N genügend groß ist, um die Kompensation der Offsetspannung mit dem geforderten Genauigkeitsgrad und über den gegebenen Timeslot zu ermöglichen;
- zweite Registermittel (21, 22, 23, 24) zum Transformieren des besagten zweiten digitalen Worts (CH1, CH2, CH3, CH4) mit einer Länge von N Bits in ein entsprechendes digitales Wort (CH1', CH2', CH3', CH4') mit einer Länge von K Bits;
- dritte Registermittel (DE-SCALER) zum Transformieren der besagten vierten digitalen Wörter (COD_OUT1, COD_OUT2, COD_OUT3, COD_OUT4) mit einer Länge von K Bits in fünfte digitale Wörter (CH1", CH2", CH3", CH4"), die den ursprünglichen gewandelten Wert wiederherstellen.

8. Zeitverschachtelter Mehrwege-Analog-Digital-Wandler (MP-ADC), der einen zusätzlichen Referenz-Analog-Digital-Wandler (ADC5) benutzt und enthält:

- Mittel (ANALOG-DEMUX) zum zyklischen Demultiplexieren des analogen Eingangssignals ($V_{in}$) für die Be-Bestandteile darstellenden Analog-Digital-Wandler (ADC1, ADC2, ADC3, ADC4);
- Mittel (DIGITAL-MUX) zum zyklischen Multiplexieren digitaler Signale (COD_OUT1, COD_OUT2, COD_OUT3, COD_OUT4) am Ausgang der besagten, Bestandteile darstellenden Analog-Digital-Wandler (ADC1, ADC2, ADC3, ADC4), so dass ein einziges digitales Ausgangssignal ($V_{out}$) erhalten wird;

**dadurch gekennzeichnet, dass** er ferner enthält:

- Mittel (SWITCHES) zum Parallelschalten des Referenz-Analog-Digital-Wandlers (ADC5) zu einem ausgewählten, einen Bestandteil darstellenden Analog-Digital-Wandler (ADC1) und Synchronisieren miteinander;
- Mittel (MUX) zum Auswählen des Ausgangssignals eines zu kalibrierenden, einen Bestandteil darstellenden Analog-Digital-Wandlers (ADC1, ADC2, ADC3, ADC4);
- Mittel (10) zum Berechnen der algebraischen Differenz zwischen ersten digitalen Wörtern (CH5) am Ausgang des Referenz-Analog-Digital-Wandlers (ADC5) und zweiten entsprechenden digitalen Wörtern (CH1, CH2, CH3, CH4) am Ausgang des ausgewählten, einen Bestandteil darstellenden Analog-Digital-Wandlers;
- Mittel (AKKUMULATOR) zum Akkumulieren der berechneten Differenzen über einen gegebenen Timeslot, so dass ein drittes digitales Wort (DH1, DH2, DH3, DH4) erhalten wird;
- Mittel (OFFSET-ALIGN) zum Addieren des dritten digitalen Worts (DH1, DH2, DH3, DH4) zu dem Ausgangssignal (CH1', CH2', CH3', CH4') des ausgewählten Analog-Digital-Wandlers, das mit einem Skalierungsfaktor multipliziert wurde, der von der Länge des gegebenen Timeslots abhängt, so dass vierte digitale Wörter (COD_OUT1, COD_OUT2, COD_OUT3, COD_OUT4) erhalten werden, die zu der Summe des besagten Ausgangssignals (CH1', CH2', CH3', CH4') und der Offsetspannung des Referenz-Analog-Digital-Wandlers (ADC5) proportional sind, und aus denen die ursprüngliche Offsetspannung vollständig eliminiert ist.

9. Zeitverschachtelter Mehrwege-Analog-Digital-Wandler (MP-ADC) nach dem vorhergehenden Anspruch, **dadurch gekennzeichnet, dass** die besagten, Bestandteile darstellenden Analog-Digital-Wandler (ADC1, ADC2, ADC3, ADC4) vom Sigma-Delta-Typ sind.

**Revendications**

1. Procédé de compensation du décalage de tension de chaque pièce composante de convertisseur analogique-numérique d'un convertisseur analogique-numérique à entrelacement temporel et à trajets multiples (MP-ADC) qui exploite un convertisseur analogique-numérique supplémentaire (ADC5) comme référence, **caractérisé en ce qu'**il est basé sur les étapes suivantes, répétées de manière cyclique pour chacune des pièces composantes de convertisseur analogique-numérique (ADC1, ADC2, ADC3, ADC4) sous étalonnage, consistant à :

- relier le convertisseur analogique-numérique de référence (ADC5) en parallèle à une pièce composante de convertisseur analogique-numérique sélectionnée (ADC1, ADC2, ADC3, ADC4) et les synchroniser l'un avec l'autre;
- calculer les différences algébriques entre des premiers mots numériques (CH5) à la sortie du convertisseur analogique-numérique de référence (ADC5) et des deuxièmes mots numériques correspondants (CH1, CH2, CH3, CH4) à la sortie de la pièce composante de convertisseur analogique-numérique sélectionnée (ADC1, ADC2, ADC3, ADC4) et accumuler les différences sur un créneau de temps donné, obtenant ainsi un troisième mot numérique (DH1, DH2, DH3, DH4);

- ajouter le troisième mot numérique (DH1, DH2, DH3, DH4) au signal de sortie (CH1', CH2', CH3', CH4') du convertisseur analogique-numérique sélectionné multiplié par un facteur d'échelle qui dépend de la longueur du créneau de temps donné, obtenant des quatrièmes mots numériques (COD_OUT1, COD_OUT2, COD_OUT3, COD_OUT4) proportionnels à la somme dudit signal de sortie (CH1', CH2', CH3', CH4') avec le décalage de tension du convertisseur analogique-numérique de référence (ADC5) et totalement dépourvus du décalage de tension d'origine.

2. Procédé de compensation du décalage de tension de chaque pièce composante de convertisseur analogique-numérique d'un convertisseur analogique-numérique à entrelacement temporel et à trajets multiples (MP-ADC) qui exploite un convertisseur analogique-numérique supplémentaire (ADC5) comme référence, **caractérisé en ce qu'**il est basé sur les étapes suivantes, répétées de manière cyclique pour chacune des pièces composantes de convertisseur analogique-numérique (ADC1, ADC2, ADC3, ADC4) sous étalonnage, consistant à :

- relier le convertisseur analogique-numérique de référence (ADC5) en parallèle à une pièce composante de convertisseur analogique-numérique sélectionnée (ADC1, ADC2, ADC3, ADC4) et les synchroniser l'un avec l'autre;
- calculer les différences algébriques entre des premiers mots numériques (CH5) à la sortie du convertisseur analogique-numérique de référence (ADC5) et des deuxièmes mots numériques correspondants (CH1, CH2, CH3, CH4) à la sortie de la pièce composante de convertisseur analogique-numérique sélectionnée (ADC1, ADC2, ADC3, ADC4) et calculer la moyenne des différences sur un créneau de temps donné, obtenant ainsi un troisième mot numérique (DH1, DH2, DH3, DH4);
- ajouter le troisième mot numérique (DH1, DH2, DH3, DH4) au signal de sortie (CH1', CH2', CH3', CH4') du convertisseur analogique numérique sélectionné, obtenant des quatrièmes mots numériques (COD_OUT1, COD_OUT2, COD_OUT3, COD_OUT4) représentant ledit signal de sortie (CH1', CH2', CH3', CH4') dépourvu du décalage d'origine et comprenant le décalage du convertisseur analogique-numérique de référence (ADC5) seulement.

3. Procédé selon la revendication 1 ou 2, **caractérisé en ce que** lesdits premiers (CH5) et deuxièmes (CH1, CH2, CH3, CH4) mots numériques ont une longueur de N bits, tandis que ledit troisième mot numérique (DH1, DH2, DH3, DH4) a une longueur de K bits, K > N étant assez grand pour permettre la compensation du décalage de tension avec le degré de précision requis et sur le créneau de temps d'accumulation.

4. Procédé selon la revendication 3 lorsqu'elle dépend de la revendication 1, **caractérisé en ce que** ledit facteur d'échelle est égal à $2^{(K-N)}$.

5. Procédé selon la revendication précédente, **caractérisé en ce que** lesdits quatrièmes mots numériques (COD_OUT1, COD_OUT2, COD_OUT3, COD_OUT4) sont divisés par ledit facteur d'échelle, obtenant des cinquièmes mots numériques (CH1", CH2", CH3", CH4") restaurant la valeur convertie d'origine.

6. Circuit de compensation de décalage de tension pour la connexion à un convertisseur analogique-numérique à entrelacement temporel et à trajets multiples (MP-ADC) comportant un convertisseur analogique-numérique supplémentaire (ADC5) comme référence, **caractérisé en ce qu'**il comprend :

- un moyen (SWITCHES) pour relier le convertisseur analogique-numérique de référence (ADC5) en parallèle à une pièce composante de convertisseur analogique-numérique sélectionnée (ADCI) et pour les synchroniser l'un avec l'autre;
- un moyen (MUX) pour sélectionner le signal de sortie d'une pièce composante de convertisseur analogique-numérique devant être étalonnée (ADC1, ADC2, ADC3, ADC4);
- un moyen (10) pour calculer les différences algébriques entre des premiers mots numériques (CH5) à la sortie du convertisseur analogique-numérique de référence (ADC5) et des deuxièmes mots numériques correspondants (CH1, CH2, CH3, CH4) à la sortie de la pièce composante de convertisseur analogique-numérique sélectionnée;
- un moyen (ACCUMULATOR) pour accumuler les différences calculées sur un créneau de temps donné, obtenant ainsi un troisième mot numérique (DH1, DH2, DH3, DH4);
- un moyen (OFFSET-ALIGN) pour ajouter le troisième mot numérique (DH1, DH2, DH3, DH4) au signal de sortie (CH1', CH2', CH3', CH4') du convertisseur analogique-numérique sélectionné multiplié par un facteur d'échelle qui dépend de la longueur du créneau de temps donné, obtenant des quatrièmes mots numériques (COD_OUT1, COD_OUT2, COD_OUT3, COD_OUT4) proportionnels à la somme dudit signal de sortie (CH1', CH2', CH3', CH4') avec le décalage de tension du convertisseur analogique-numérique de référence (ADC5) et totalement dépourvus du décalage de tension d'origine.

7. Circuit de compensation de décalage de tension selon la revendication précédente, **caractérisé en ce qu'**il comprend :

- des premiers moyens formant registres (11) pour transformer lesdites différences d'une longueur de N bits en différences d'une longueur de K bits délivrées en entrée audit moyen d'accumulation (ACCUMULATOR), K > N étant assez grand pour permettre la compensation du décalage de tension avec le degré de précision nécessaire et sur le créneau de temps donné;
- des deuxièmes moyens formant registres (21, 22, 23, 24) pour transformer ledit deuxième mot numérique (CH1, CH2, CH3, CH4) d'une longueur de N bits en un mot numérique correspondant d'une longueur de K bits (CH1', CH2', CH3', CH4');
- des troisièmes moyens formant registres (DE-SCALER) pour transformer lesdits quatrièmes mots numériques (COD_OUT1, COD_OUT2, COD_OUT3, COD_OUT4) d'une longueur de K bits en cinquièmes mots numériques (CH1", CH2", CH3", CH4") restaurant la valeur convertie d'origine.

8. Convertisseur analogique-numérique à entrelacement temporel et à trajets multiples (MP-ADC) exploitant un convertisseur analogique-numérique de référence supplémentaire (ADC5), comprenant :

- un moyen (ANALOG-DEMUX) pour démultiplexer de manière cyclique le signal d'entrée analogique ($V_{in}$) vers les pièces composantes de convertisseur analogique-numérique (ADC1, ADC2, ADC3, ADC4);
- un moyen (DIGITAL-DEMUX) pour multiplexer de manière cyclique les signaux numériques (COD_OUT1, COD_OUT2, COD_OUT3, COD_OUT4) à la sortie desdites pièces composantes de convertisseur analogique-numérique (ADC1, ADC2, ADC3, ADC4), obtenant un unique signal de sortie numérique ($V_{out}$);

**caractérisé en ce qu'**il comprend en outre :

- un moyen (SWITCHES) pour relier le convertisseur analogique-numérique de référence (ADC5) en parallèle à une pièce composante de convertisseur analogique-numérique sélectionnée (ADC1) et pour les synchroniser l'un avec l'autre;
- un moyen (MUX) pour sélectionner le signal de sortie d'une pièce composante de convertisseur analogique-numérique devant être étalonnée (ADC1, ADC2, ADC3, ADC4);
- un moyen (10) pour calculer la différence algébrique entre des premiers mots numériques (CH5) à la sortie du convertisseur analogique-numérique de référence (ADC5) et des deuxièmes mots numériques correspondants (CH1, CH2, CH3, CH4) à la sortie de la pièce composante de convertisseur analogique-numérique sélectionné;
- un moyen (ACCUMULATOR) pour accumuler les différences calculées sur un créneau de temps donné, obtenant ainsi un troisième mot numérique (DH1, DH2, DH3, DH4);
- un moyen (OFFSET-ALIGN) pour ajouter le troisième mot numérique (DH1, DH2, DH3, DH4) au signal de sortie (CH1', CH2', CH3', CH4') du convertisseur analogique-numérique sélectionné multiplié par un facteur d'échelle qui dépend de la longueur du créneau de temps donné, obtenant des quatrièmes mots numériques (COD_OUT1, COD_OUT2, COD_OUT3, COD_OUT4) proportionnels à la somme dudit signal de sortie (CH1', CH2', CH3', CH4') avec le décalage de tension du convertisseur analogique-numérique de référence (ADC5) et totalement dépourvus du décalage de tension d'origine.

9. Convertisseur analogique-numérique à entrelacement temporel et à trajets multiples (MP-ADC) selon la revendication précédente, **caractérisé en ce que** lesdites pièces composantes de convertisseur analogique-numérique (ADC1, ADC2, ADC3, ADC4) sont du type sigma delta.

# FREQUENCY SPECTRUM OF THE RECEIVED SAMPLED SIGNAL

**Fig.1**

# SIGMA-DELTA ADC (KNOWN ART)

**Fig.2**

EP 1 401 105 B1

# TIME-INTERLEAVED ADC
## (KNOWN ART)

ANALOG DEMUX

ADC-BANK

DIGITAL MUX

Vin

$F_{CK}$     7

$F_{CK}/M$

$F_{CK}$     8

Vout

**Fig.3**

# OVERALL TIME-INTERLEAVED SIGMA-DELTA ADC TRANSFER FUNCTION (KNOWN ART)

**Fig.4**

EP 1 401 105 B1

# OVERALL FREQUENCY ATTENUATION SPECTRUM OF FIG.4's STF

**Fig.5**

# ADC$_i$ WITH VOLTAGE-OFFSET ON-LINE DIGITAL CALIBRATOR (KNOWN ART)

**Fig.6**

EP 1 401 105 B1

# TIME-INTERLEAVED ADC WITH VOLTAGE-OFFSET ON-LINE DIGITAL COMPENSATION CIRCUIT

**Fig.7**

EP 1 401 105 B1

# TIME DIAGRAM OF THE INTERLEAVED ADC

Fig.8

EP 1 401 105 B1

# ON-LINE VOLTAGE-OFFSET DIGITAL
# COMPENSATION CIRCUIT

**Fig.9**

EP 1 401 105 B1

OFFSET COMPENSATION CIRCUIT - PART 1

Fig.10a

# OFFSET COMPENSATION CIRCUIT - PART 2

**Fig.10b**

EP 1 401 105 B1

# MULTI-PATH ADC POWER SPECTRAL DENSITY

Fig.11